**Europäisches Patentamt**

**European Patent Office**

**Office européen des brevets**

(19)

(11) Veröffentlichungsnummer : **0 120 192**
**B1**

(12) # EUROPÄISCHE PATENTSCHRIFT

(45) Veröffentlichungstag der Patentschrift :
07.09.88

(21) Anmeldenummer : 84100365.0

(22) Anmeldetag : 14.01.84

(51) Int. Cl.⁴ : **B 32 B 31/08, B 31 F 5/00**

(54) **Verfahren zur kontinuierlichen Herstellung kupferkaschierter Elektrolaminate und Vorrichtung zur Durchführung des Verfahrens.**

(30) Priorität : 01.03.83 DE 3307057

(43) Veröffentlichungstag der Anmeldung :
03.10.84 Patentblatt 84/40

(45) Bekanntmachung des Hinweises auf die Patenterteilung : 07.09.88 Patentblatt 88/36

(84) Benannte Vertragsstaaten :
CH FR GB IT LI SE

(56) Entgegenhaltungen :
CH-A-  566 209
DE-A- 1 924 110
DE-A- 2 648 088
DE-A- 2 920 722
US-A- 4 295 912

(73) Patentinhaber : **Held, Kurt**
**Alte Strasse 1**
**D-7218 Trossingen 2 (DE)**

(72) Erfinder : **Held, Kurt**
**Alte Strasse 1**
**D-7218 Trossingen 2 (DE)**

## Beschreibung

Die Erfindung betrifft ein Verfahren zur kontinuierlichen Herstellung von ein- oder zweiseitig kupferkaschierten Elektrolaminaten aus einem Träger und Isolationsmaterial mit einer oder zwei Elektrolytkupferfolien von hohem Reinheitsgrad gemäß dem Oberbegriff des Patentanspruchs 1 und eine Vorrichtung zur Durchführung des Verfahrens gemäß dem Oberbegriff des Patentanspruchs 7.

Mit der Einführung der Transistortechnik ist man mehr und mehr vom herkömmlichen Chassis als Träger der Bauelemente und der herkömmlichen Verdrahtung abgekommen. Durch automatische Bestückung der Leiterplatte und Lötung in automatischen Lötprozessen ist eine Großserienfertigung von elektronischen Geräten erreicht worden, die eine weite Verbreitung der Konsumelektronik in Rundfunk-, Fernseh- und Phonoindustrie erst ermöglicht hat. Damit entsteht in der elektronischen Industrie ein stetig steigender Bedarf an qualitativ hochwertigen kupferkaschierten Elektrolaminaten, dem Ausgangsprodukt für Leiterplatten. Aufgrund des großen Bedarfs ist ein Verfahren zur billigen Herstellung von Elektrolaminaten, das sich leicht zur Massenproduktion einsetzen läßt, anzustreben. Weiter müssen bei derartigen Elektrolaminaten Fehlstellen in der Kupferfolienoberfläche vermieden werden, damit eine sichere Funktionsfähigkeit der elektronischen Geräte gewährleistet ist. Verbesserungen der Qualität der Produktionsverfahren solcher Laminate kommen daher eine entscheidende Bedeutung zu.

Kupferkaschierte Elektrolaminate bestehen nach DIN 40 802 Blatt 2 aus einem ein- oder zweiseitig mit Elektrolyt-Kupferfolie mit einem Reinheitsgrad von mindestens 99,5 % kaschierten Schichtpreßstoff. Dabei dient der Schichtstoff als Träger- und Isolationsmaterial, die Kupferschicht zur Herstellung der Leiterbahnen. Bei Elektrolaminaten haben drei Produkte Bedeutung erlangt. Bei diesen besteht der Schichtstoff aus Hartpapier Epoxidhartpapier oder Epoxyharz-Glasgewebe.

Immer häufiger, vor allem in der Fernmeldetechnik, wo mit Höchstfrequenzen gearbeitet wird, wird das Epoxyharz-Glasgewebe, trotz des höheren Preises gegenüber dem Hartpapier, verwendet. Die Vorteile dieses Elektrolaminats sind hohe mechanische Festigkeit, bessere elektrische Werte bei Feuchtigkeitseinwirkung und die geringen dielektrischen Verluste bei hohen Frequenzen.

Die Fertigung der Elektrolaminate läuft wie folgt ab. Die Papier- oder Gewebebahnen für den Schichtstoff, beispielsweise Glasfaserbahnen werden mit Harz, das als Bindemittel wirkt, imprägniert. Gebräuchlich sind dafür Epoxypolyester, Phenol oder Melamin. Anschließend werden die imprägnierten Bahnen getrocknet, wobei das Harz bis zum gewünschten Grad vorkondensiert wird. Bei der weiteren Verarbeitung wird eine elektrolytisch abgeschiedene Kupferfolie auf ein Preßblech gelegt und darauf werden die imprägnierten Bahnen nach dem gewünschten Schichtstoffaufbau und der Laminatdicke in der dafür benötigten Anzahl verlegt. Falls eine zweiseitige Kupferbeschichtung erwünscht ist, kann die Oberfläche mit einer weiteren elektrolytisch abgeschiedenen Kupferfolie abgedeckt werden. Anschließend werden die einzelnen Bahnen in einem Hochdruckpreßverfahren unter Wärmeeinwirkung zu einem Laminat verpreßt. Dabei verklebt die Kupferfolie mit dem Schichtstoffkern zu einem kompakten Elektrolaminat. Ein anschließendes Besäumen des Preßrandes aus drucklos ausgehärtetem Harz und Kontrollieren des fertigen Produktes vervollständigen den Fertigungsablauf.

Bei diesem Herstellungsverfahren ist der kritische Punkt das Preßverfahren. Um die Funktionsfähigkeit einer Leiterplatte zu sichern, ist durch Sauberkeit beim Pressen zu vermeiden, daß die Kupferfläche Falten, Perforationen oder Preßeindrücke erhält, die zu Leiterbahnunterbrechungen führen können. Preßeindrücke entstehen dadurch, daß kleine Staubkörner durch elektrostatische Ladungen von metallischen Oberflächen, also auch vom Preßblech und der Kupferfolie angezogen werden, die beim Pressen die Kupferfolie zwar nicht unbedingt beschädigen und elektrisch unterbrechen müssen, aber doch einbeulen. Diese Preßeindrücke können bei der Weiterverarbeitung des Elektrolaminats zu einer Leiterplatte, die üblicherweise durch Drucken und Ätzen erfolgt, zu Druck- und Ätzfehlern führen. Da das Hartpapier oder das Gewebe und die Kupferfolie einen stark unterschiedlichen thermischen Längenausdehnungskoeffizienten besitzen, können bei unterschiedlicher Erwärmung der Laminatbestandteile in der Presse während des Verklebens der Kupferfolie mit dem Schichtstoff Falten und Ablösungen entstehen. Eine nicht auf dem Schichtstoffkern festhaftende Kupferfläche ist jedoch als Elektrolaminat nicht zu gebrauchen.

Zur Verpressung der einzelnen Schichten der Elektrolaminate wird üblicherweise eine diskontinuierlich arbeitende Etagenpresse benutzt. Beim Einziehen der Schichtstoffbahnen in die Presse kann es kaum vermieden werden, daß aus den einzelnen Bahnen Staub aufgewirbelt wird, der sich dann durch elektrostatische Anziehung auf der Kupferfolien- und Preßblechoberfläche absetzt. Besonders gravierend wird dieses Problem bei der Verwendung von Glasfaserbahnen für den Schichtstoff, wo dann feiner Glasfaserstaub aufgewirbelt wird. Die verunreinigte Kupferoberfläche führt dann, wie oben erläutert, zu Fehlstellen in der Leiterplatte, womit ein Teil des Laminats unbrauchbar wird. Bedingt durch die Erwärmung in der Presse und des unterschiedlichen thermischen Längenausdehnungskoeffizienten von Schichtstoff und Kupferfolie, kommt es zu unterschiedlichen Längenausdehnungen derselben während des Aushärtens des Harzes, wodurch Fehlstellen durch Falten und Ablösungen entstehen. Außerdem können die Fertigungskapazitäten durch die diskontinuierliche Arbeitsweise in der Presse nicht optimal ausgenutzt werden.

Ein kontinuierliches Verfahren zur Herstellung von Elektrolaminaten, das mit einer Doppelbandpresse arbeitet, ist aus der DE-A-2 648 088 bekannt geworden. Bei diesem Verfahren ist vor der Doppelbandpresse ein Förderband angeordnet, auf das eine von einer Rolle abgewickelte Kupferfolie aufgelegt wird. Auf diese Kupferfolie wird ein duroplastisches Harz aufgetragen und anschließend werden Trägermaterialbahnen, die von Abwickelrollen vor der Doppelbandpresse abgewickelt werden, in die Harzschicht, die sich auf der Kupferfolie befindet, eingedrückt. Danach wird eine weitere Kupferfolie von einer Abwickelrolle abgewickelt und auf die Oberfläche dieser Trägerbahn aufgelegt. Dieser so gebildete Schichtkörper wird mittels des Förderbandes in die Doppelbandpresse eingeführt und dort unter Wärme- und Flächendruckeinwirkung zum kupferkaschierten Elektrolaminat verpreßt. Hinter der Doppelbandpresse kann das kupferkaschierte Elektrolaminat mittels einer Schneidevorrichtung in Platten zerteilt werden.

Die Doppelbandpresse besitzt zur Ausübung des Flächendrucks auf den Innenseiten der Preßbänder angeordnete Druckplatten. Diese Druckplatten können in eine Heiz- und Kühlzone eingeteilt sein. An der Unterseite des Förderbandes ist eine Reinigungseinrichtung angeordnet, beispielsweise eine Bürstenrolle, zur Entfernung des auf dem Förderband befindlichen Schmutzes.

Nachteilig bei diesem bekannten Verfahren ist, daß sobald eine Kupferfolienrolle oder eine Rolle für die Trägermaterialbahnen aufgebraucht ist, die Produktion unterbrochen und die leere Rolle gegen eine neue Rolle ausgetauscht werden muß. Es entstehen dabei Stillstandszeiten, die die Effektivität des ansonsten wünschenswerten kontinuierlichen Verfahrens herabsetzen. Ebenfalls nachteilig ist, daß eine Verhinderung von Falten, Ablösungen und schädlichen Preßeindrücken während der Verpressung zum Elektrolaminat nicht gewährleistet ist. Zwar ist am Förderband eine Reinigungseinrichtung vorhanden. Diese ist jedoch nicht geeignet, den sich auf den Kupferfolien und den Preßbändern der Doppelbandpresse absetzenden Staub, also dort wo er zu den schädlichen Einflüssen führt, zu entfernen. Die gezeigte Vorrichtung bietet auch keine Gewähr, daß das Elektrolaminat bei unterschiedlichen Temperaturen der Preßbänder in der Doppelbandpresse genügend aushärtet. Dieses kontinuierliche Verfahren liefert daher keine qualitativ den Anforderungen genügende Elektrolaminate.

Zur Vermeidung von Runzeln oder Dellen in der Metallfolie einer Schichtplatte aus thermoplastischem Kunstharz und einem Metall schlägt die CH-A-566 209 vor, Metallfolien oder -bleche, die mit einer Thermoplastbahn zwischen einem Paar von Druckwalzen verpreßt werden, unmittelbar vor den Druckwalzen auf annähernd der Temperatur der Druckwalzen vorzuwärmen. Die Vorwärmung kann beispielsweise mittels Infrarotstrahler erfolgen. Das in dieser Patentschrift gezeigte, mit Druckwalzen arbeitende Verfahren eignet sich nicht zur Verpressung von Schichtstoffen, wie Elektrolaminaten, die mit duroplastischen Harzen imprägniert sind, da von den Druckwalzen kein Flächendruck ausgeübt wird. Dieses gattungsfremde Verfahren kann daher keine Anregung geben, wie Fehlstellen bei der Herstellung von Elektrolaminaten vermieden werden können.

Da in der elektronischen Industrie ein immer größerer Bedarf an Elektrolaminaten besteht, kommt einem kontinuierlich arbeitenden Verfahren zur Herstellung von Elektrolaminaten, das die Fertigungskapazitäten optimal ausnützt und Ausschuß durch Fehlstellen in der Kupferoberfläche vermeidet, größte Bedeutung zu.

Der Erfindung liegt die Aufgabe zugrunde, das gattungsgemäße Verfahren zur kontinuierlichen Herstellung von Elektrolaminaten so zu verbessern, daß eine Steigerung der Produktion durch Verkleinerung der Stillstandszeiten unter Verringerung der durch Staubeinschlüsse, Falten und Ablösungen verursachten Fehlstellen ermöglicht wird.

Die Lösung dieser Aufgabe wird durch die im Kennzeichen des Patentanspruchs 1 beschriebene technische Lehre vermittelt. Eine zur Durchführung des erfindungsgemäßen Verfahrens dienende Vorrichtung ist durch die technische Lehre im Kennzeichen des Patentanspruchs 7 gegeben.

Die mit der Erfindung erzielbaren Vorteile bestehen darin, daß keine Stillstandszeiten zum Austausch von Rollen für die Bahnen des Schichtstoffkerns oder der Kupferfolien während der Produktion erforderlich sind, so daß der Ausstoß an Elektrolaminaten erhöht wird. Durch Anpassung der Temperaturen der Kupferfolie und der Schichtstoffbahnen vor dem Aushärten des Harzes ist ein riß- und wölbungsfreies Aufbringen der Kupferfolie möglich. Fremdkörper auf der Kupferfolie werden unmittelbar vor Einlauf in die Presse durch einen Abstreifer entfernt, so daß Fehlstellen in der Leiterplatte weitgehend vermieden werden können. Der bei bisherigen Herstellverfahren unvermeidliche Preßrand entlang der Elektrolaminatplatte oder -bahn der als unbrauchbar abgeschnitten werden muß, entfällt, die fertige Bahn kann in voller Breite verwendet werden. Durch diese Maßnahmen werden daher Quantität und Qualität des kontinuierlichen Herstellungsverfahrens für Elektrolaminate gesteigert.

Die zur Durchführung des erfindungsgemäßen Verfahrens verwendete Vorrichtung wird anhand der beigefügten Zeichnungen beschrieben. Es zeigen

Fig. 1 eine Produktionsanlage zur kontinuierlichen Herstellung von Elektrolaminaten,

Fig. 2 Abstreifer für Staub und Fremdkörper vor der Laminiermaschine,

Fig. 3 Abwickeleinheiten für Schichtstoff- und Kupferfolienbahnen,

Fig. 4 Randabstützung des Laminats in der Laminiermaschine,

Fig. 5 Produktionsanlage zur kontinuierlichen Herstellung von MultiLayer-Platten,

Fig. 6 Elektrolaminatbahn mit Fixierbohrungen in Draufsicht und

Fig. 7 Stiftketteneingriff in der Laminiermaschine.

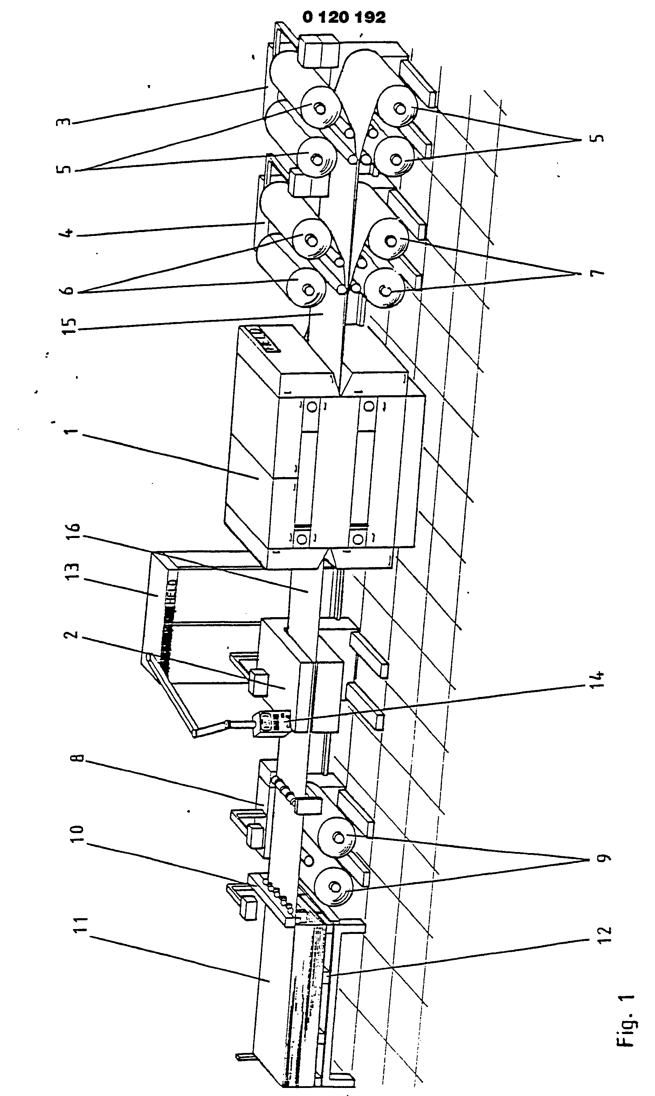

Die in Fig. 1 schematisch dargestellte Vorrichtung besteht aus einer kontinuierlich arbeitenden Laminiermaschine 1, einer mit Lösungsmittel arbeitenden Kühl- und Reinigungseinrichtung 2, Abwickeleinheiten 3 und 4 mit Vorratsrollen 5 für den Schichtstoff und 6, 7 für die Kupferfolie, einer Wickelstation 8 mit Rollen 9 für dünne Elektrolaminate, einer mitlaufenden Schere 10 und einem Schaltschrank 13 mit Datensichtgerät 14. Das fertige Endprodukt liegt als Bogenware 11 auf Paletten 12.

Die einzelnen mit Harz imprägnierten Bahnen, beispielsweise Glasfaser- oder Hartpapierbahnen für den Schichtstoffkern des Elektrolaminats werden von Rollen 5 abgewickelt und entsprechend des gewünschten Schichtstoffaufbaus in die kontinuierlich arbeitende Laminiermaschine 1 eingeführt. Als Laminiermaschine wird eine Doppelbandpresse verwendet, die zur kontinuierlichen Herstellung von dekorativen Schichtpressstoffen bekannt ist. Auf eine bzw. beide Oberflächen des Schichtstoffkerns wird die elektrolytisch abgeschiedene Kupferfolie 15 gelegt, die ebenfalls von einer Rolle 6 bzw. 7 abgewickelt wird.

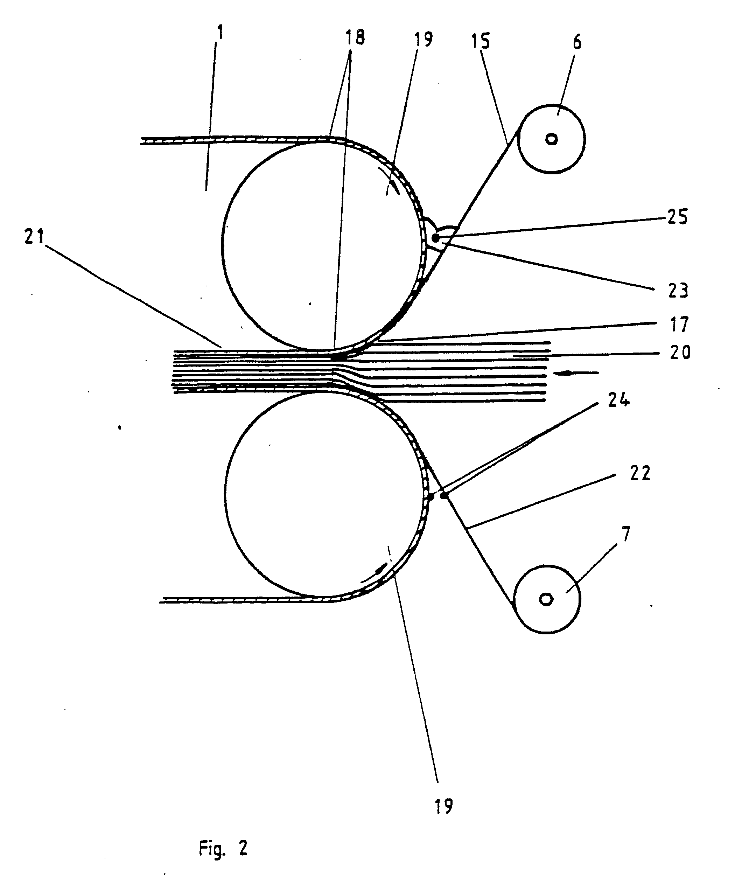

Die Rolle 6 mit der Kupferfolie wird, wie in Fig. 2 gezeigt, so vor der Laminiermaschine 1 angebracht, dass die Kupferfolie 15 erst in der Einlaufzone 17, die aus den beiden Pressbändern 18 und Umlenktrommeln 19 gebildet wird, auf den Schichtstoffkern 20 zum Anliegen kommt. Vor Einlauf in diesen Pressspalt wird die Kupferfolie 15 an dem auf der Umlenktrommel laufenden Pressband 18 entlanggeführt, so dass sich die Temperatur der Kupferfolie der zur Aushärtung des Harzes für den Schichtstoffkern 20 nötigen Verfahrenstemperatur anpassen kann. Ein Vorwärmen der Kupferfolie ist wegen der hohen Wärmeleitfähigkeit von Kupfer und den stark unterschiedlichen thermischen Längenausdehnungskoeffizienten von den Kupfer- und Schichtstoffbahnen nötig. Durch diese Massnahme wird erreicht, dass die Längenausdehnung der Kupferfolie 15 bereits in der Einlaufzone 17 das Maximum erreicht und während des Verklebvorgangs der Kupferfolie mit dem Schichtstoffkern keine Längenänderungen mehr stattfinden, die zu Rissen und Ablösungen führen können, da das Harz in der Presszone 21 noch nicht vollständig ausgehärtet ist. Zur Unterstützung der Vorwärmphase für die Kupferfolie 15 kann die Laminiermaschine so ausgestaltet sein, dass eine Beheizung der Umlenktrommel 19 in der Einlaufzone 17 möglich ist. Zur weiteren Unterstützung dieser Massnahme oder alternativ kann auch eine zusätzliche Wärmequelle für die Kupferfolie 15 vor der Einlaufzone 17 angeordnet sein, so dass eine Vorwärmung der Kupferfolie auf Verfahrenstemperatur erfolgt, ohne dass die Kupferfolie auf dem an der Umlenktrommel 19 laufenden Pressband 18 entlanggeführt werden muss.

Wird ein beidseitig kupferkaschiertes Elektrolaminat gewünscht, so kann eine zweite Elektrolytkupferfolie 22 von einer zweiten Rolle 7 abgewickelt und auf die Rückseite des Schichtstoffkerns aufgelegt werden. Auch diese Folie wird zur Anpassung der Temperatur und Länge beim Einlauf in die Doppelbandpresse 1 an die untere Umlenktrommel 19 gem. Fig. 2 angelegt oder mittels einer zusätzlichen Wärmequelle auf Verfahrenstemperatur vorgewärmt.

Um die Temperaturanpassung noch effektiver zu gestalten, sowie um Verwerfungen des Elektrolaminats bei druckloser Abkühlung zu vermeiden, kann die Doppelbandpresse selbst in eine Heiz- und eine Kühlzone eingeteilt sein, wobei die Einlauf- und Presszone als Heizzonen ausgebildet sind, so dass hier die Vorwärmung der Kupferfolie und anschliessend die Aushärtung des Schichtstoffkerns und Verklebung desselben mit der Kupferfolie durch Wärme und Druck erfolgen kann. In der dem Auslauf aus der Doppelbandpresse zugewandten Kühlzone erfolgt schliesslich die Abkühlung des Elektrolaminats.

Gemäss einer weiteren Ausgestaltung der Erfindung kann die Produktion von einseitig kupferkaschierten Elektrolaminaten ungefähr verdoppelt werden. Das Schichtgebilde besteht dabei aus einer Kupferfolie und der für die Schichtdicke der ersten Elektrolaminatbahn benötigten Anzahl von Schichtstoffbahnen, gefolgt von einer Trennfolie, der Anzahl von Schichtstoffbahnen für die zweite Elektrolaminatbahn und abschliessend einer weiteren Kupferfolie. Die Trennfolie, die beispielsweise aus Edelstahl oder dgl. bestehen kann, wird von einer Rolle vor der Laminiermaschine abgewickelt. Sie kann vor Eintritt in die Reaktionszone durch hier nicht dargestellte, an sich bekannte Einrichtungen auf eine zweckmässig erhöhte Temperatur aufgeheizt sein. Hinter der Laminiermaschine erfolgt die Trennung der beiden Elektrolaminatbahnen, was durch die Trennfolie ermöglicht wird, und getrennte Aufwicklung oder Zerteilung in Bogenware, während die Trennfolie ebenfalls auf eine Rolle aufgewickelt wird.

Der beim Einlauf der Schichtstoffbahnen in die Presse unvermeidlich aufgewirbelte Staub, der sich durch elektrostatische Anziehung auf metallischen Oberflächen, so auch auf der Kupferfolienoberfläche und dem Pressband, absetzt, wird mit Hilfe von Abstreifern 23 und 24, wie ebenfalls in Fig. 2 gezeigt, kurz vor dem Einlauf in die Presse entfernt. Dieser aus einem elastischen und wärmebeständigen Material, beispielsweise Kunststoff, Kunststoff-Filz oder Elastomer, bestehende Abstreifer liegt mit einer Seite dicht auf der Oberfläche der Kupferfolie 15 auf, mit der anderen Seite auf dem an der Umlenktrommel 19 vorbeigeführten Pressband 1. Mit dieser Massnahme wird der abgesetzte Staub von der Folie und dem Pressband entfernt, bevor er durch Einpressung zu Fehlstellen in der Elektrolaminatoberfläche führen kann.

Fig. 2 zeigt zwei mögliche Ausbildungsformen für den Abstreifer 23, 24. Der Abstreifer 23 ist lippenförmig gestaltet, so dass sich eine Lippe an die Kupferfolienoberfläche und die andere an das Pressband anlegt. Der von den Oberflächen entfernte Staub sammelt sich in der Abstreifermitte in einer Art Kanal 25, von wo er beispielsweise mit Reinluft aus diesem axial aus der Maschine herausgeblasen werden kann. Diese Ausbildungsform für den Abstreifer eignet sich besonders gut in Zusammenhang mit der oben erwähnten Vorwärmmassnahme für die Kupferfolie, wobei diese am Pressband entlang in die Einlaufzone der Laminiermaschine eingeführt wird. Dabei entsteht zwischen Kupferfolie 15 und und Pressband 18 kurz vor der Einlaufzone der Laminiermaschine ein keilförmiger Spalt, in dem ein solchermassen ausgestalteter Abstreifer eingelegt werden kann.

Eine weitere Möglichkeit ist die Ausbildung des Abstreifers 24 in Schnurform. Diese Schnur besitzt eine geschlossene Form, so dass ein Teil der Schnur auf der gesamten Breite des Pressbandes, der andere Teil auf der gesamten Breite der Kupferfolienoberfläche aufliegt und über beide Oberflächen etwas hinausragt. In dem Spalt zwischen der Oberfläche und der Schnur sammelt sich der Staub. Wird diese Schnur nun axial über die beiden Oberflächen bewegt, so lässt sich der Staub und Schmutz axial aus der Einlaufzone herausziehen.

Der Abstreifer kann aber auch aus zwei einzelnen getrennten Abstreifern bestehen, wobei der eine auf der Kupferfolienoberfläche und der andere auf der Pressbandoberfläche in der Nähe der Einlaufzone dicht aufliegt. Diese sammeln den Schmutz vor Einlauf in die Laminiermaschine. Besonders gut eignet sich eine solche Ausführungsform, wenn die Kupferfolie durch eine Zusatzwärmequelle vorgewärmt und nicht entlang des Pressbandes in die Laminiermaschine eingeführt wird. Da die Kupferfolien- und Pressbandoberflächen beim Einlauf in die Laminiermaschine von Verunreinigungen befreit sind, werden Fehlstellen im Elektrolaminat weitgehend vermieden.

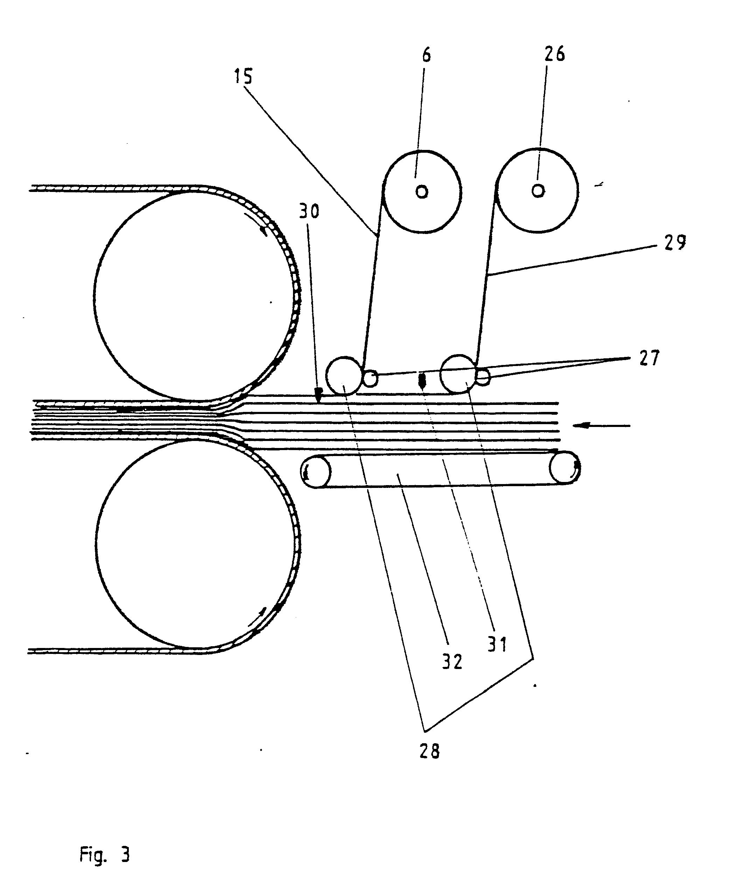

Ist eine Schichtstoff- oder Kupferfolienrolle aufgebraucht, so muss die Produktion angehalten, die verbrauchte Rolle ersetzt und deren Bahn neu in die Maschine eingefädelt werden, ehe die Produktion- wieder aufgenommen werden kann. Um diesen Produktionsausfall zu vermeiden, wird, wie in Fig. 3 gezeigt, für jede benötigte Rolle 6 mindestens eine weitere Vorratsrolle 26 vor der Maschine aufgebaut. Die einzelnen Rollen sind mit motorbetriebenen Antriebsrollen 27, die zur Abwicklung und zum Abbremsen der einzelnen Bahnen dienen, und Umlenkrollen 28 vesehen. Kurz bevor nun eine solche Folienbahn 15 zu Ende geht, wird die Bahn 29 von der Vorratsrolle 26 gestartet und deren Anfang mittels einer Schere 31 senkrecht abgeschnitten. Die zu Ende gehende Bahn 15 wird ebenfalls mittels einer Schere 30 senkrecht abgeschnitten und die weitere Abwicklung der Rolle 6 gestoppt. Aus dem Abstand der beiden Scheren und der Vorschubgeschwindigkeit der zu verpressenden Bahnen in der Laminiermaschine lassen sich die Zeipunkte für die einzelnen Schnitte leicht berechnen, so dass die Laminatproduktion nur wenige Millimeter zwischen zwei Rollen unterbrochen wird.

Zum leichten Einfädeln der neuen Rollenanfänge kann unterhalb der Rollen ein Transportband 32 mitlaufen, das dieselbe Vorschubgeschwindigkeit wie die Laminatbahn in der Laminiermaschine besitzt und bis in deren Einlaufzone hineinreicht.

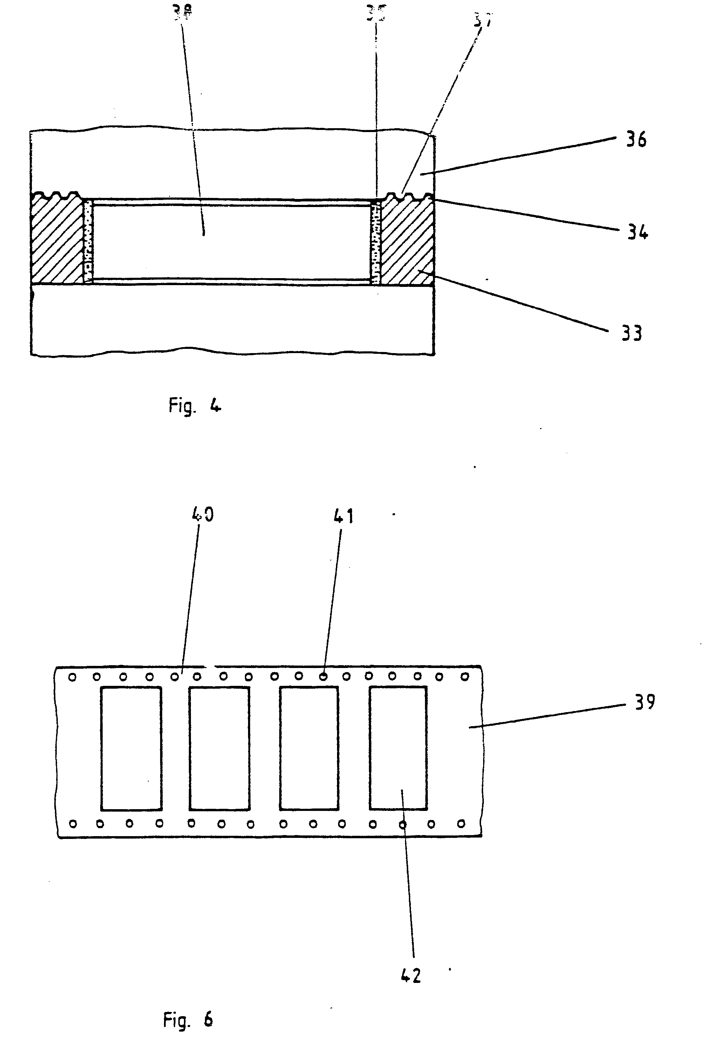

Die geforderte Dickentoleranz, die beispielsweise nach DIN 40 605 und DIN 40 606 genormt ist, wird durch die folgende Massnahme erreicht, die in Fig. 4 gezeigt ist. In der Laminiermaschine läuft eine Randleiste 33 mit. Diese dient zur Randabstützung, um die geforderte Schichtdicke des Laminats 38 zu gewährleisten. Im Pressband 36 der Laminiermaschine ist eine Profilierung 37 eingedreht, in die das Gegenstück 34 der Randleiste greift. Damit wird eine gerade Führung der Randleiste 33 erreicht. Zwischen Randleiste 33 und zu verpressendem Laminat 38 bleibt ein Zwischenraum 35 von rund 1,6 mm Breite, der zur Aufnahme des überschüssigen Harzes dient, das beim Verpressen aus den Schichtstoffbahnen austritt. Damit entsteht kein drucklos ausgehärteter Pressrand, der nach Verlassen des Elektrolaminats aus der Maschine abgeschnitten werden müsste. Die Elektrolaminatbahn kann daher in voller Breite verwendet werden.

Nach Verlassen der Laminiermaschine wird das noch endlos anfallende Elektrolaminat 16 mittels einer mitlaufenden Schere 10 in Bogenware 11 zerteilt, um in handelsüblichen Grössen auf den Markt gebracht zu werden und auf Paletten 12 zum leichten Abtransport gestapelt. Alternativ kann auch, falls gewünscht, das dünne Elektrolaminat 16 auf Rollen 9 in der Wickelstation 8 gewickelt werden. Bevor das endlose Elektrolaminat in Einzelstücke zerteilt wird, kann es im Anschluss an die Doppelbandpresse eine Kühlstation 2 mit Lösemittelbad durchlaufen. Das Kühlmittel wirkt dann zusätzlich als Reinigungsmittel zur Säuberung und Entfettung der Kupferoberfläche, so dass ein weiteres Bearbeiten des Elektrolaminats, beispielsweise durch Bedrucken mit Ätzresistflächen und Ätzen der Leiterbahnen anschliessend sofort erfolgen kann.

Die Vorschubgeschwindigkeit der zu verpressenden Bahnen in der Laminiermaschine ist abhängig von der Dicke des Laminats und der Temperatur der Pressbänder. Um diese Einflussgrössen optimal berücksichtigen zu können, wird die Vorschubgeschwindigkeit mittels eines Geschwindigkeits-Temperatur-Rechners anhand der oben genannten Parameter geregelt. Dieser Geschwindigkeits-Temperatur-Rechner ist im Schaltschrank 13 untergebracht. Von diesem Schaltschrank aus werden auch die übrigen Funktionen der in Fig. 1 gezeigten Produktionsanlage gesteuert. Zur Eingabe der für die Steuerung notwendigen Prozessparameter dient das Datensichtgerät 14.

Besonders vorteilhaft kann eine solche Produktionsanlage auch zur Herstellung von Multi-Layer-Platten angewendet werden.

Bei Multi-Layer-Platten werden mehrere einzelne Leiterplatten zu einem Paket verklebt. Dadurch erreicht man eine grössere Freizügigkeit in der Leiterbahnführung, da man sie zur kreuzungsfreien Führung auf mehreren Ebenen anordnen kann. Das dabei entstehende Problem ist allerdings, dass ein passgenaues Aufbringen der Ätzresistflächen möglich sein muss. Weiter muss das nachfolgende Bearbeiten wie Schneiden, Bohren, Stanzen, Fräsen, usw. ebenfalls passgenau erfolgen, damit gewünschte Durchkontaktierungen und Verbindungen zwischen den einzelnen Leiterplatten erfolgen können.

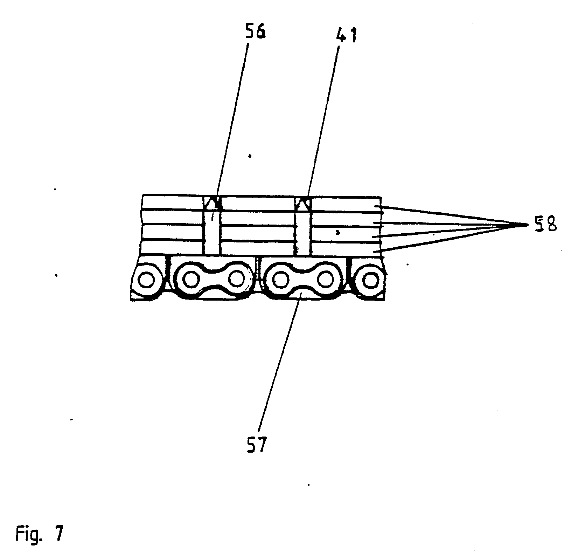

Die Justierung für das passgenaue Bearbeiten erfolgt mittels eines Lochrandes 40, der an beiden Rändern des Elektrolaminats 39 angebracht ist. Fig. 6 zeigt eine Draufsicht auf das endlose Elektrolaminat 39 mit dem Lochrand 40. In diesem Lochrand befinden sich Fixierbohrungen 41, deren Mittelpunkte einen konstanten Abstand voneinander besitzen. In Referenz zu diesen Fixierbohrungen 41 lassen sich dann Ätzresistflächen 42 zum Ätzen der Leiterbahnen festlegen. Die anschliessende Bearbeitung erfolgt ebenfalls in Referenz zu diesen Fixierbohrungen. Das Einbringen dieses Lochrandes wird durch Stanzen vorgenommen, nachdem die endlose Elektrolaminatbahn die Laminiermaschine 1 und Kühleinrichtung 2 verlassen hat. Das Stanzen der einzelnen Löcher erfolgt, vom Rechner gesteuert, mit einer Frequenz, die von der Vorschubgeschwindigkeit der Elektrolaminatbahn in der Laminiermaschine abhängig ist. Damit wird erreicht, dass die Abstände der einzelnen Fixierbohrungen unter allen Betriebsbedingungen der Produktionsanlage gleich bleiben, was für die präzise Herstellung der Multi-Layer-Platte unerlässlich ist.

Für die Weiterverarbeitung der Elektrolaminatbahn bieten sich zwei verschiedene Vorgehensweisen an. Bei der ersten wird die endlose Elektrolaminatbahn anhand der Fixierbohrungen in einzelne Layerplatten zerschnitten, die dann getrennt durch Ätzen, Bohren, Stanzen, Fräsen, u. dgl. bearbeitet werden können, wobei als Referenz jeweils die Fixierbohrungen dienen. Bei der zweiten Vorgehensweise wird die endlose Elektrolaminatbahn nicht in einzelne Leiterplatten zerschnitten, sondern die einzelnen Muster für die Layer werden in Referenz zum Lochrand im Band verbleibend belichtet oder aufgedruckt und anschliessend geätzt. Damit erhält man ein Laminat, auf dem sich, durch vorherbestimmte Abstände getrennt, immer dasselbe Layer wiederholt. Für die weiteren Layer werden ebenfalls solche Laminatbahnen angefertigt, auf denen sich wieder ein Layer mit dem gleichen Abstand wie auf den übrigen Laminatbahnen wiederholt. Diese Laminatbahnen können anschliessend gleich weiterverarbeitet oder bis zur späteren Verarbeitung zweckmässigerweise in Rollen aufgewickelt werden.

Zur Verpressung der einzelnen Layerbänder zu einem Multi-Layer-Band, oder der einzelnen Layer Platten zu einer Multi-Layer-Platte werden die einzelnen Laminatbahnen mit den aufgebrachten Layern anhand der Fixierbohrungen zentriert in der gewünschten Reihenfolge aufeinandergelegt, wobei sich dazwischen jeweils eine Klebschichtbahn befindet, und anschliessend Druck und Wärme ausgesetzt. Dazu wird eine Produktionsanlage verwendet, die eine leichte Modifizierung der obigen Produktionsanlage ist.

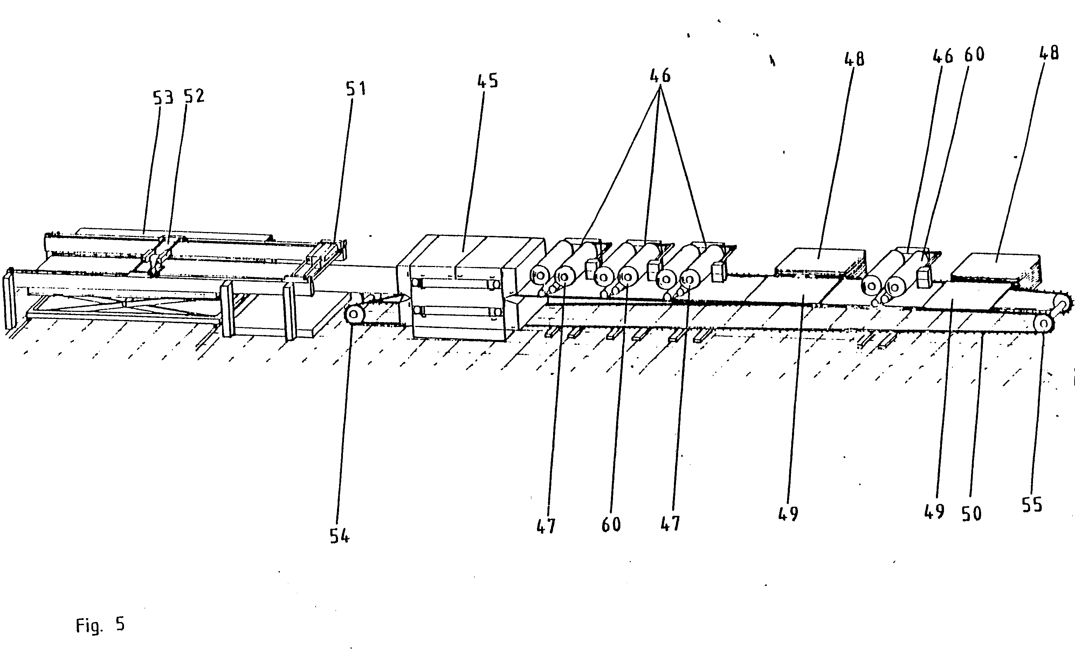

Diese Produktionsanlage ist in Fig. 5 schematisch gezeigt und besteht aus einer kontinuierlich arbeitenden Laminiermaschine 45, Abwickeleinheiten 46 für die einzelnen Layer-Bahnen 47 und Klebschichtbahnen 60, einer Auflegeeinheit 48 für die Layer-Platten 49, einer Stiftketteneinrichtung 50, einer Tafelschneide- oder Stanzstation 51 und einer Aufnahmeeinrichtung 52 für die einzelnen Multi-Layer-Platten 53.

Die einzelnen Layer-Bahnen 47, auf denen sich die bereits geätzten Leiterplatten jeweils in Referenz zu den Fixierbohrungen befinden, laufen von den Abwickeleinheiten 46 über ein Rollenbett oder ein mitlaufendes Transportband in die kontinuierlich arbeitende Laminiermaschine 45, die aus einer Doppelbandpresse besteht. Es sind dabei so viele Abwickeleinheiten notwendig wie die Anzahl der Layer und Klebschichten der Multi-Layer-Platte beträgt. Die Reihenfolge der Anordnung der Abwickeleinheiten entspricht dem Aufbau der Multi-Layer-Platte. Zwischen den Layer-Bahnen liegt jeweils eine Klebschichtbahn 60, die mit einem vorkondensierten duroplastischen Harz getränkt ist und ebenfalls von Abwickeleinheiten 46 abgewickelt wird. Die Zentrierung der einzelnen Layer-Schichten passgenau übereinander wird mit Hilfe der Stiftkette 50 erreicht, deren Zähne genau denselben Abstand wie die Fixierbohrungen besitzen. Diese läuft mit derselben Geschwindigkeit wie die Multi-Layer-Bahnen an deren linkem und rechtem Rand unter den Abwickeleinheiten zur Laminiermaschine und wird nach Verlassen derselben über eine Umlenkrolle 54 zum Anfang zurückgeleitet, wo sie durch eine weitere Umlenkrolle 55 wieder auf die Laminiermaschine zuläuft. Das Auflegen der Anfänge der einzelnen Layer-Bahnen auf die Stiftkette muss mit Hilfe der Zentrierbohrungen so erfolgen, dass die jeweils ersten Leiterplatten beim Einlauf in die Laminiermaschine übereinander liegen. Mit Hilfe der Stiftkette, die mit einer Genauigkeit von 1/100 mm hergestellt werden kann, und den passgenauen Fixierbohrungen sind die einzelnen auf der Laminatbahn ausgeätzten Layerschichten automatisch zentriert, da sie aufgrund ihrer weiter vorne beschriebenen Herstellung eine festgelegte Lage zu den Fixierbohrungen besitzen.

Liegen die einzelnen Layer-Schichten in Plattenform vor, so werden diese in der benötigten Reihenfolge mittels einer Auflegeeinheit 48 in der benötigten Reihenfolge und Anzahl aufeinandergelegt. Dabei geht man wie folgt vor. Die erste Layer-Platte 49 wird auf eine Stiftkette 50 aufgelegt und in Richtung Laminiermaschine 45 transportiert.

Darüber liegt eine Klebschichtbahn 60, die von einer Rolle abgewickelt wird. Beim Passieren der Auflegeeinheit für die nächste Layer-Schicht wird diese ausgerichtet anhand der Fixierbohrungen auf die erste Schicht und die Stiftkette aufgelegt.

Durch den Eingriff der Stiftzähne 56, die die Stiftkette 57 besitzt, in die einzelnen Fixierbohrungen 41, wie in Fig. 7 gezeigt, werden die einzelnen Layer-Schichten 58 automatisch vollständig zentriert, da die Fixierbohrungen sehr präzise gestanzt und die Stiftkette mit geringen Toleranzen gefertigt werden können. Im weiteren Lauf zur Laminiermaschine werden nacheinander die noch folgenden Klebschichtbahnen und Layer-Schichten zentriert auf die Stiftkette aufgelegt.

Beim Einlauf in die Laminiermaschine 45 sind die einzelnen Layer-Schichten, die in Platten- oder Bahnenform vorliegen, bereits zentriert und werden in dieser durch Wärme und Druck zu einer Multi-Layer-Platte oder Bahn verklebt. Da die Stiftkette am linken und rechten Rand der Bahnen oder Platten mitläuft, können diese sich auch unter der Druck- und Reibungseinwirkung in der Presse nicht verschieben und bleiben daher bis zur Aushärtung des Harzes zentriert.

Nach Verlassen der Laminiermaschine 45 wird die Stiftkette von der Multi-Layer-Bahn abgehoben und über eine Umlenkrolle 54 zu ihrem Anfang zurückgelenkt. In der Tafelschneide- oder Stanzstation 51 werden die Multi-Layer-Platten, falls sie noch in Bahnenform vorliegen, ausgestanzt oder ausgeschnitten in einzelne Multi-Layer-Platten. Wurden einzelne Layer-Platten verwendet, so wird in der Schneidestation 51 der nunmehr überflüssige Lochrand besäumt. Die einzelnen Multi-Layer-Platten werden anschliessend in der Aufnahmestation 52, die beispielsweise aus einem Vakuumtransportgerät besteht, in Stapeln 53 aufeinandergereiht. In diesen Stapeln werden sie dann zur Weiterverarbeitung abtransportiert.

## Patentansprüche

1. Verfahren zur kontinuierlichen Herstellung ein- oder zweiseitig kupferkaschierter Elektrolaminate aus einem Träger- und Isolationsmaterial mit einer oder zwei Elektrolyt-Kupferfolien von hohem Reinheitsgrad, bei dem die Bahnen für den das Trägermaterial bildenden Schichtstoffkern von Vorratsrollen abgewickelt und aufeinander geschichtet werden, eine oder zwei elektrolytisch abgeschiedene Kupferfolien mit gleicher Geschwindigkeit mit einer Seite oder mit der Ober- und Unterseite des Schichtstoffkerns zu einem Schichtgebilde zusammengeführt werden, dieses Schichtgebilde einer Pressung unter Flächendruck zwischen zwei Endlosbändern zur Elektrolaminatbahn mit anschließender Abkühlung unterworfen wird und die Elektrolaminatbahn gegebenenfalls in Platten beliebiger Länge zerteilt wird, dadurch gekennzeichnet, daß die Bahnen für den Schichtstoffkern bereits auf der Vorratsrolle als mit Harz imprägnierte Bahnen vorliegen, bei jeder Vorratsrolle für die Schichtstoffkern- und Kupferfolienbahnen eine Ersatzrolle angeordnet wird, deren Bahn abgewickelt wird, sobald die Bahn der Vorratsrolle aufgebraucht ist, um einen unterbrechungsfreien Betrieb zu gewährleisten, die Kupferfolien auf Verfahrenstemperatur, die die zur Aushärtung für das Harz des Schichtstoffkerns benötigte Temperatur darstellt, gebracht werden und damit ihre größte Länge aufgrund der thermischen Längenausdehnung bereits erreicht haben bevor sie mit dem Schichtstoffkern zusammengeführt werden, der Staub, der sich auf den metallischen Oberflächen der Kupferfolien und Endlosbänder durch elektrostatische Anziehung absetzt, mittels Abstreifer kurz bevor das Schichtgebilde zwischen die beiden Endlosbänder einläuft entfernt wird, die Geschwindigkeit der einzelnen Bahnen für das Schichtgebilde entsprechend den für die Bandtemperatur ermittelten Verweilzeiten des Schichtgebildes zwischen den Endlosbändern mittels eines Geschwindigkeit-Temperatur-Rechners gesteuert wird und die Elektrolaminatbahn nach Verlassen der Endlosbänder auf Rollen aufgewickelt oder in Paletten gestapelt wird, falls sie in Platten zerteilt wird.

2. Verfahren nach Anspruch 1, dadurch gekennzeichnet, daß zur gleichzeitigen Herstellung zweier einseitig kupferkaschierter Elektrolaminatbahnen eine aus Metall bestehende Trennfolie in der Trennebene zwischen den beiden Elektrolaminatbahnen im Schichtstoffkern bei der Verpressung zwischen den Endlosbändern mitgeführt wird, so daß die beiden Elektrolaminatbahnen nach Verlassen der Endlosbänder durch die Trennfolie leicht trennbar sind.

3. Verfahren nach Anspruch 2, dadurch gekennzeichnet, daß die Trennfolie von einer Rolle abgewickelt, in die Trennebene in den Schichtstoffkern vor der Verpressung eingeführt und nach dem Trennen der beiden Elektrolaminatbahnen wieder auf eine Rolle aufgewickelt wird.

4. Verfahren nach Anspruch 2 oder 3, dadurch gekennzeichnet, daß die Trennfolie vor dem Einlauf zwischen die beiden Endlosbänder auf erhöhte Temperatur erwärmt wird.

5. Verfahren nach einem der Ansprüche 1 bis 4, dadurch gekennzeichnet, daß die Elektrolaminatbahn nach Verlassen der beiden Endlosbänder mit einem Lösungsmittel gekühlt wird, so daß die Kupferoberfläche des Elektrolaminats gleichzeitig mit der Kühlung gereinigt und entfettet wird.

6. Verfahren nach einem der Ansprüche 1 bis 5, dadurch gekennzeichnet, daß an beiden Rändern des Schichtgebildes Fixierbohrungen in regelmäßigen Abständen bei oder nach der Verpressung zwischen den Endlosbändern eingebracht werden.

7. Vorrichtung zur Durchführung des Verfahrens nach einem der Ansprüche 1 bis 6, bestehend aus Abwickeleinheiten mit Vorratsrollen für die Bahnen für den Schichtstoffkern und die Kupferfolien, aus einer kontinuierlich arbeitenden, einen Flächendruck ausübenden Doppelbandpresse, deren Reaktionszone eine dem Einlauf zugeordnete Heizzone und gegebenenfalls eine dem Auslauf zugeordnete Kühlzone aufweist und gegebenenfalls aus einer hinter der Doppelbandpresse angeordneten Schneideinrichtung zur Aufteilung der kupferkaschierten Elektrolaminatbahn in Platten, dadurch gekennzeichnet, daß jeder Vorratsrolle (5, 6, 7) für die Schichtstoff und Kupferfolienbahnen in den Abwickeleinheiten (3, 4) mindestens eine Ersatzrolle mit eigenen Antriebs- und Bremseinheiten zugeordnet ist, die eine Weiterführung der endenden, senkrecht abgeschnittenen Vorratsrollenbahn durch die beginnende, ebenfalls senkrecht abgeschnittene Ersatzrollenbahn mit geringem Abstand ermöglicht, daß am oder vor dem Einlauf in die Doppelbandpresse (1) eine Wärmequelle zum Vorheizen der Kupferfolien (15, 22) angeordnet ist, um die Kupferfolien (15, 22) bis zur Zusammenführung mit den Bahnen für den Schichtstoffkern (20) auf Verfahrenstemperatur zu erwärmen, daß die Doppelbandpresse (1) an ihrem Einlauf einen Schmutzabstreifer (23, 24) aufweist, der mit einer Fläche auf der Oberfläche des Preßbandes (18) und mit einer anderen Fläche auf der Oberfläche der Kupferfolie (15, 22) dicht aufliegt, daß die Doppelbandpresse (1) eine Steuereinrichtung (13) mit einem Geschwindigkeits-Temperatur-Rechner aufweist, der die Vorschubgeschwindigkeit der beiden Preßbänder abhängig von deren Temperatur steuert und daß hinter der Doppelbandpresse (1) eine Wickelstation (8) mit einer Rolle (9) für die Elektrolaminatbahn (16) oder bei der Schneidestation (10) sich Paletten (12) zur Stapelung der Bogenware (11) befinden, falls die Elektrolaminatbahn (16) in Platten aufgeteilt wird.

8. Vorrichtung nach Anspruch 7, dadurch gekennzeichnet, daß hinter der Doppelbandpresse (1) eine Kühlstation (2) mit einem Lösemittelbad angeordnet ist, so daß das Kühlmittel zusätzlich als Reinigungsmittel wirkt.

9. Vorrichtung nach den Ansprüchen 7 oder 8, dadurch gekennzeichnet, daß jede der Vorrats- und Ersatzrollen (6, 26) in der Abwickeleinheit (3, 4) je eine Schere (30, 31) zum gerade Schneiden der Anfänge und Enden der Bahnen (15, 29) besitzt und daß unterhalb der Rollen (6, 26) ein zum leichten Einfädeln der Bahnanfänge in die Doppelbandpresse (1) dienendes Förderband (32) angeordnet ist, das mit derselben Geschwindigkeit wie die Bahnen (15, 29) bis zum Einlauf in die Doppelbandpresse (1) mitläuft.

10. Vorrichtung nach einem der Ansprüche 7 bis 9, dadurch gekennzeichnet, daß zum Vorheizen der Kupferfolien (15, 22) deren Vorratsrollen (6, 7) und zugehörige Abwickeleinheit (4) vor der Doppelbandpresse (1) so angebracht sind, daß die Kupferfolien (15, 22) vor Zusammenführung mit den Bahnen für den Schichtstoffkern (20) an dem Preßband (18) anliegen, das sich auf einer der Einlaufzone (17) zugeordneten Umlenktrommel (19) befindet und die Kupferfolien (15, 22) dadurch auf die Verfahrenstemperatur und ihre dadurch bedingte größte Länge gebracht werden.

11. Vorrichtung nach Anspruch 10, dadurch gekennzeichnet, daß die Umlenktrommel (19) für das Preßband (18) mit einer Wärmequelle versehen ist.

12. Vorrichtung nach einem der Ansprüche 7 bis 11, dadurch gekennzeichnet, daß der aus einem wärmebeständigen und elastischen Material bestehende Schmutzabstreifer (23) eine lippenförmige Form und einen durchgehenden Kanal (25) besitzt, wobei eine Lippe auf der Oberfläche des Preßbandes (18) und die andere Lippe auf der Oberfläche der Kupferfolie (15) dicht aufliegt, so daß sich der abgestreifte Schmutz im Kanal (25) sammelt.

13. Vorrichtung nach einem der Ansprüche 7 bis 12, dadurch gekennzeichnet, daß der Schmutzabstreifer (24) eine schnurförmige geschlossene Form besitzt, wobei ein Teil der Schnur auf der Preßbandoberfläche (18), der andere Teil auf der Kupferfolienoberfläche (22) kurz vor Einlauf in die Doppelbandpresse (1) fest aufliegt, und diese Schnur axial über die Metalloberflächen so beweglich ist, daß der Schmutz aus der Einlaufzone (17) herausgezogen wird.

14. Vorrichtung nach einem der Ansprüche 7 bis 13, dadurch gekennzeichnet, daß der Schmutzabstreifer aus zwei getrennten Abstreifeinheiten gebildet ist, wobei die eine auf der Kupferfolienoberfläche, die andere auf der Preßbandoberfläche kurz vor der Einlaufzone (17) aufliegt.

15. Vorrichtung nach einem der Ansprüche 7 bis 14, dadurch gekennzeichnet, daß links und rechts neben dem Elektrolaminat (38) zwischen den Preßbändern (36) der Doppelbandpresse (1) eine mitlaufende profilierte Randleiste (33) zur Randabstützung der Preßbänder vorgesehen ist, deren Profilierung (34) in das entsprechende Gegenstück (37) eines Preßbandes (36) zur geraden Führung eingreift, womit die Dickentoleranz des Elektrolaminats (38) auch in der Randzone gewährleistet ist.

16. Vorrichtung nach einem der Ansprüche 7 bis 15, dadurch gekennzeichnet, daß die Fixierbohrungen (41) nach dem Verpressen der Elektrolaminatbahn (39) mit Hilfe einer Stanzvorrichtung in die Elektrolaminatbahn (39) eingebracht werden.

17. Vorrichtung nach Anspruch 16, dadurch gekennzeichnet, daß mehrere einzelne Layer-Platten (49), zwischen denen sich Klebschichtbahnen (60) befinden, die von Abwickeleinheiten (46) abgewickelt werden, mit Hilfe der Fixierbohrungen (41) und den Stiftzähnen (56) einer von den Auflegeeinheiten (48) durch die Laminiermaschine (45) hindurchlaufenden Stiftkette (50) mit einer Genauigkeit von mindestens 1/100 mm zentriert, zu der Laminiermaschine (45) transportiert und anschließend in der Laminiermaschine (45) unter Einwirkung von Wärme und Druck zu einer Multi-Layer-Platte verklebt werden.

18. Vorrichtung nach Anspruch 16, dadurch gekennzeichnet, daß mehrere einzelne Layer-Bahnen (47), auf denen sich durch vorherbestimmte Abstände getrennte Einzellayer befinden, mit dazwischengelegten Klebschichtbahnen (60), die von Abwickeleinheiten (46) abgewickelt werden, mit Hilfe der Fixierbohrungen (41) und den Stiftzähnen (56) einer von den Abwickeleinheiten (46) durch die Laminiermaschine (45) hindurchlaufenden Stiftkette (50) mit einer Genauigkeit von mindestens 1/100 mm zentriert, zu der Laminiermaschine (45) transportiert und anschließend in der Laminiermaschine (45) unter Einwirkung von Wärme und Druck zu einer Multi-Layer-Bahn verklebt werden.

## Claims

1. Method for the continuous manufacture of one-sidedly or double-sidedly copper-clad electrical laminates of a carrier and insulating material with one or two electrolytic copper foils of a high degree of purity, in which method the webs for the layer substance core forming the carrier material are unwound from supply rolls and laid one upon the other, one or two electrolytically deposited upper foils are brought together at equal speed with one side or with the upper and lower side of the layer substance core to a layer formation, this layer formation is subjected to a pressing under areal pressure between two endless belts into an electrical laminate web with subsequent cooling and the electrical laminate web is in a given case divided up into plates of desired length, characterised thereby, that the webs for the layer substance core are present already on the supply roll as webs impregnated with resin, a replacement roll is arranged near each supply roll for the webs of the layer substance core and the copper foil and its web is unwound as soon as the web of the supply roll is used up in order to assure an uninterrupted operation, the copper foils are brought to process temperature, which represents the temperature needed for the setting of the resin of the layer substance core, and have thereby already attained their greatest length by reason of the thermal length expansion before they are brought together with the layer substance core, the dust, which due to electrostatic attraction deposits on the metallic surfaces of the copper foils and endless belts, is removed by means of wipers shortly before the layer formation runs in between both the endless belts, the speed of the individual webs for the layer formation is controlled by means of a speed-temperature computer in accordance with the dwell times, determined for the belt temperature, of the layer formation between the endless belts and the electrical laminate web after leaving the endless belts is wound on rolls or, in case it is divided into plates, stacked on pallets.

2. Method according to claim 1, characterised thereby, that for the simultaneous manufacture of two one-sidedly copper-clad electrical laminate webs, a separating foil consisting of metal is carried along in the separating plane between both the electrical laminate webs in the layer substance core during the pressing-together between the endless belts so that both the electrical laminate webs after leaving the endless belts are easily separable by the separating foil.

3. Method according to claim 2, characterised thereby, that the separating foil is unwound from a roll, introduced into the separating plane in the layer substance core before the pressing-together and after the separation of both the electrical laminate webs again wound onto a roll.

4. Method according to claim 2 or 3, characterised thereby, that the separating foil is heated to increased temperature before running in between both the endless belts.

5. Method according to one of the claims 1 to 4, characterised thereby, that the electrical laminate web after leaving both the endless belts is cooled by a solvent so that the copper surface of the electrical laminate is cleaned and degreased simultaneously with the cooling.

6. Method according to one of the claims 1 to 5, characterised thereby, that fixing bores are introduced in regular spacings at both edges of the layer formation during or after the pressing-together between the endless belts.

7. Apparatus for the performance of the method according to one of the claims 1 to 6, consisting of unwinding units with supply rolls for the webs for the layer substance core and the copper foils, of a continuously operating double-belt press, which exerts an areal pressure and the reaction zone of which displays a heating zone associated with the inlet and, in a given case, a cooling zone associated with the outlet and, in a given case, of a cutting device arranged behind the double belt press for dividing the copper-clad electrical laminate web up into plates, characterised thereby, that each supply roll (5, 6, 7) for the webs of the layer substance core and the copper foil in the unwinding units (3, 4) is associated with at least one replacement roll with own driving and braking units, which makes possible a continuation of the ending, perpendicularly severed supply roll web by the beginning, likewise perpendicularly severed replacement roll web at a small spacing, that a heat source for the preheating of the copper foils (15, 22) is arranged at or before the inlet into the double belt press (1) in order to heat the copper foils (15, 22) to process temperature until being brought together with the webs for the layer substance core (20), that the double belt press (1) at its inlet displays a dirt wiper (23, 24), which lies closely by one area on the surface of the press belt (18) and by another area on the surface of the copper foil (15, 22) that the double belt press (1) displays a control equipment (13) with a speed-temperature computer which controls the speed of advance of both the press belts in dependence on their temperature and that a winding station (8) with a roll (9) for the electrical laminate web (16) is disposed behind the double belt press (1) or, in case the electrical laminate web (16) is divided up into plates, pallets (12) for the stacking of the sheetware (11) are disposed at the cutting station (10).

8. Apparatus according to claim 7, characterised thereby, that a cooling station (2) with a solvent bath is arranged behind the double belt press (1) so that the coolant additionally acts as cleaning agent.

9. Apparatus according to the claims 7 or 8, characterised thereby, that each of the supply and replacement rolls (6, 26) in the unwinding unit (3, 4) possesses respective shears (30, 31) for the straight cutting of the beginnings and ends of the webs (15, 29) and that a conveyor belt (32), which runs along at the same speed as the webs (15, 29) to the inlet into the double belt press (1) and which serves for the easy threading of the beginnings of the webs into the double belt press (1), is arranged underneath the rolls (6, 26).

10. Apparatus according to one of the claims 7 to 9, characterised thereby, that for the preheating of the copper foils (15, 22), their supply rolls (6, 7) and associated unwinding unit (4) are so mounted in front of the double belt press (1) that the copper foils (15, 22) before being brought together with the webs for the layer substance core (2) lie against the press belt (18), which is disposed on a deflecting drum (19) associated with the inlet zone (17), and the copper foils (15, 22) are thereby brought to the process temperature and their greatest length caused thereby.

11. Apparatus according to claim 10, characterised thereby, that the deflecting drum (19) for the press belt (18) is provided with a heat source.

12. Apparatus according to one of the claims 7 to 11, characterised thereby, that the dirt wiper (23) consists of a heat-resistant and elastic material and possesses a lip shape and a continuous channel (25), wherein one lip lies closely on the surface of the press belt (18) and the other lip lies closely on the surface of the copper foil (15) so that the dirt, that is wiped off, collects in the channel (25).

13. Apparatus according to one of the claims 7 to 14, characterised thereby, that the dirt wiper (24) possesses a string-shaped closed shape, wherein one part of the string lies firmly on the press belt surface (18) and the other part lies firmly on the copper foil (22) shortly before running into the double press belt (1), and this string is so movable axially across the metal surfaces that the dirt is drawn out of the inlet zone (17).

14. Apparatus according to one of the claims 7 to 14, characterised thereby, that the dirt wiper is formed of two separate wiper units, wherein the one lies on the copper foil surface and the other lies on the press belt surface shortly before the inlet zone (17).

15. Apparatus according to one of the claims 7 to 14, characterised thereby, that provided for the edge support of the press belts to the right and left beside the electrical laminate (38) between the press belts (36) of the double belt press (1), there is a co-running profiled edge strip (33), the profiling (34) of which engages for straight guidance into the corresponding counterpiece (37) of a press belt (36), whereby the thickness tolerance of the electrical laminate (38) is assured also in the edge zone.

16. Apparatus according to one of the claims 7 to 15, characterised thereby, that the fixing bores (41) are introduced into the electrical laminate web (39) with the aid of a punching device after the pressing-together of the electrical laminate web (39).

17. Apparatus according to claim 16, characterised thereby, that several individual layer plates (49), between which adhesive layer webs (60) are disposed, which are unwound from unwinding units (46), are centred to an accuracy of at least 0.01 millimetres with the aid of the fixing bores (41) and the pin teeth (56) of a pin chain (50) running from the feeder units (48) through the laminating machine (45), are transported to the laminating machine (45) and subwequently glued together into a multi-layer plate under the influence of heat and pressure in the laminating machine (45).

18. Apparatus according to claim 16, characterised thereby, that several individual layer webs (47), on which are disposed individual layers separated by predetermined spacings, with interposed adhesive layer webs (60), which are unwound from unwinding units (46), are centred to an accuracy of at least 0.01 millimetres with the aid of the fixing bores (41) and the pin teeth (56) of a pin chain (50) running from the unwinding units (46) through the laminating machine (45), are transported to the laminating machine (45), and subsequently glued together into a multi-layer web under the influence of heat and pressure in the laminating machine (45).

## Revendications

1. Procédé de fabrication continue d'électrolaminés revêtus de cuivre sur un ou deux côtés, à partir d'un matériau de support et d'isolation muni d'une ou deux feuilles de cuivre électrolytique à haut degré de pureté, dans lequel les bandes du noyau de stratifié formant le matériau de support sont déroulées à partir de rouleaux d'alimentation, et placées en couches superposées, une ou deux feuilles de cuivre déposées électrolytiquement avançant à la même vitesse qu'un côté ou que le côté supérieur et le côté inférieur du noyau de stratifié, pour être réunies en une couche, cette couche étant soumise à un pressage sous l'effet d'une pression de surface appliquée entre deux bandes sans fin pour obtenir un électrolaminé, puis à un refroidissement appliqué aussitôt après, la bande électrolaminé étant, le cas échéant, subdivisée en plaquettes de la longueur voulue, procédé caractérisé en ce que les bandes utilisées pour le noyau de stratifié existent déjà sur le rouleau d'alimentation sous la forme de bandes imprégnées de résine, et en ce qu'un rouleau de rechange est prévu pour chacun des rouleaux d'alimentation des bandes de noyau stratifié ou des feuilles de cuivre, les bandes étant déroulées des rouleaux de rechange dès que les bandes des rouleaux d'alimentation sont terminées, afin de garantir un fonctionnement sans la moindre interruption, les feuilles de cuivre étant portées à la température du processus constituant la température nécessitée par le durcissement de la résine du noyau stratifié, et ces feuilles atteignant ainsi leur plus grande longueur du fait de la dilatation thermique, avant d'être réunies au noyau stratifié, la poussière qui se dépose du fait de l'attraction électrostatique sur les surfaces métalliques des feuilles de cuivre et des bandes sans fin étant éliminée au moyen de racleurs, peu avant que la couche soit introduite entre les deux bandes sans fin, la vitesse des bandes individuelles étant commandée pour chaque couche en fonction des temps de séjour de cette couche entre les bandes sans fin, au moyen d'un calculateur de vitesse-température, et la bande d'électrolaminé après avoir quitté les bandes sans fin, étant enroulée sur des rouleaux ou empilée sur des palettes dans le cas où elle est subdivisée en plaquettes.

2. Procédé selon la revendication 1, caractérisé en ce qu'une feuille de séparation se composant d'un métal est guidée dans le plan de séparation entre les deux bandes d'électrolaminés à noyau de stratifié, en les accompagnant lors du pressage entre les bandes sans fin, dans le cas où l'on fabrique simultanément deux bandes d'électrolaminés revêtues de cuivre sur un côté, ceci de telle sorte qu'après avoir quitté les bandes sans fin, les deux bandes d'électrolaminés soient facilement séparables grâce à la feuille de séparation.

3. Procédé selon la revendication 2, caractérisé en ce que la feuille de séparation est déroulée d'un rouleau, introduite avant pressage dans le plan de séparation du noyau stratifié, et enroulée à nouveau sur un rouleau après séparation des deux bandes d'électrolaminés.

4. Procédé selon l'une quelconque des revendications 2 et 3, caractérisé en ce que la feuille de séparation est préchauffée à une température élevée, avant introduction entre les deux bandes sans fin.

5. Procédé selon l'une quelconque des revendications 1 à 4, caractérisé en ce qu'après avoir quitté les deux bandes sans fin, la bande d'électrolaminé est refroidie avec un produit solvant, de telle sorte que la surface du cuivre de l'électrolaminé soit nettoyée et dégraissée en même temps que le refroidissement.

6. Procédé selon l'une quelconque des revendications 1 à 5, caractérisé en ce que des trous de fixation sont percés à intervalles réguliers sur les deux bordures de la couche, lors du pressage entre les deux bandes sans fin ou après ce pressage.

7. Dispositif pour l'exécution du procédé selon l'une quelconque des revendications 1 à 6, comprenant des unités de déroulement munies de rouleaux d'alimentation pour les bandes de noyau de stratifié et les feuilles de cuivre, une presse double bande travaillant en continu et exerçant une pression de surface, dont la zone de réaction possède une zone de chauffage affectée à l'introduction et le cas échéant une zone de refroidissement affectée à la sortie, et le cas échéant un dispositif de découpe disposé derrière la presse double bande pour subdiviser en plaquettes la bande d'électrolaminé revêtue de cuivre, dispositif caractérisé en ce qu'au moins un rouleau de rechange muni d'unités d'entraînement et de freinage propres, est affecté à chaque rouleau d'alimentation (5, 6, 7) pour les bandes de stratifiés et les bandes de feuilles de cuivre dans les unités de déroulement (3, 4), pour permettre le prolongement avec un écart limité, de la bande de rouleau d'alimentation terminée et découpée perpendiculairement, par la bande de rouleau de rechange qui commence, cette dernière étant également découpée perpendiculairement, en ce qu'une source de chaleur est disposée à l'endroit de l'introduction ou avant l'introduction dans la presse à double bande, pour le préchauffage des feuilles de cuivre (15, 22), afin de réchauffer ces feuilles de cuivre (15, 22) à la température du processus jusqu'à la réunion avec les bandes de noyau de stratifié (20), en ce que la presse double bande (1) possède à l'entrée un racleur de poussières (23, 24) s'appuyant de manière étanche par une face sur la surface de la bande de pressage (18), et par l'autre face sur la surface de la feuille de cuivre (15, 22), en ce que la presse double bande (1) possède un dispositif de commande (13) muni d'un calculateur de vitesse-température qui commande la vitesse d'avancement des bandes de pressage en fonction de leur température, et en ce que derrière la presse double bande (1) se trouvent une station d'enroulement (8) munie d'un rouleau (9) pour la bande d'électrolaminé (16), ou des palettes (12), dans le cas de la station de découpe (10) pour empiler les feuilles (11) lorsque les électrolaminés (16) sont subdivisés en plaquettes.

8. Dispositif selon la revendication 7, caractérisé en ce qu'une station de refroidissement (2) est disposée derrière la presse double bande (1) avec un bain de fluide solvant, de telle sorte que le fluide de refroidissement serve en outre de fluide de nettoyage.

9. Dispositif selon l'une quelconque des revendications 7 et 8, caractérisé en ce que chacun des rouleaux d'alimentation et de rechange (6, 26) situés dans l'unité de déroulement (3, 4) possède un couteau (30, 31) de découpe droite des amorces et des fins de bandes (15, 29), et en ce qu'au-dessous des rouleaux (6, 26) est disposée une bande transporteuse (32) servant à faciliter l'enfilage des amorces de bandes dans la presse à double bande (1), cette bande transporteuse accompagnant les bandes avec une vitesse d'avancement identique, jusqu'à l'introduction dans la presse double bande (1).

10. Dispositif selon l'une quelconque des revendications 7 à 9, caractérisé en ce que pour réaliser le préchauffage des feuilles de cuivre (15, 22), leurs rouleaux d'alimentation (6, 7) et l'unité de déroulement correspondante (4) sont disposés avant la presse double bande (1), de telle sorte que les feuilles de cuivre (15, 22), avant leur réunion avec les bandes de noyau de stratifié (20) appuient sur la bande de pressage (18) se trouvant sur un tambour de renvoi (19) affecté à la zone d'introduction (17), et en ce que les feuilles de cuivre (15, 22) sont de ce fait portées à la température du processus et par conséquent à leur plus grande longueur conditionnée par cette température.

11. Dispositif selon la revendication 10, caractérisé en ce nue le tambour de renvoi (19) de la bande de pressaqe (18) est muni d'une source de chaleur.

12. Dispositif selon l'une quelconque des revendications 7 à 11, caractérisé en ce que le racleur de poussières (23) constitué d'un matériau élastique résistant à la chaleur, se présente sous forme de lèvres avec un canal médian (25) l'une des lèvres s'appuyant pour cela de manière étanche sur la surface de la bande de pressage (18), l'autre lèvre s'appuyant sur la surface de la feuille de cuivre (15) de telle sorte que la poussière raclée s'accumule dans le canal (25).

13. Dispositif selon l'une quelconque des revendications 7 à 12, caractérisé en ce que le racleur de poussières (24) présente une forme de cordon fermé s'appuyant pour cela rigidement, peu avant l'introduction dans la presse à double bande, sur la surface de bande de pressaqe (18) pour une partie du cordon et sur la surface de feuille de cuivre (22) pour l'autre partie de ce cordon, celui-ci étant mobile axialement sur les surfaces métalliques de telle sorte que la poussière soit extraite de la zone d'introduction (17).

14. Dispositif selon l'une quelconque des revendications 7 à 13, caractérisé en ce que le racleur de poussières est formé de deux unités de raclage séparées s'appuyant pour cela, peu avant la zone d'introduction (17), sur la surface de feuille de cuivre pour l'une des unités et sur la surface de bande de pressage pour l'autre.

15. Dispositif selon l'une quelconque des revendications 7 à 14, caractérisé en ce qu'une bande de bordure (33) destinée à l'appui des bandes de pressage, est prévue sur les côtés gauche et droit de l'électrolaminé (38) entre les bandes de pressage (36) de la presse double bande (1). le profilage (34) de ces bandes s'engrenant dans la contre-pièce correspondante (37) d'une bande de pressage (36) pour réaliser un guidage exact de façon que la tolérance d'épaisseur de l'électrolaminé (38) soit ainsi également garantie dans la zone de bordure.

16. Dispositif selon l'une quelconque des revendications 7 à 15, caractérisé en ce que les trous de fixation (41) sont percés à l'aide d'un dispositif d'estampage dans la bande d'électrolaminé après le pressage de la bande d'électrolaminé (39).

17. Dispositif selon la revendication 16, caractérisé en ce que plusieurs plaquettes de couches (49) entre lesquelles se trouvent des bandes à couche de colle (60) déroulées à partir d'unités de déroulement (56), sont centrées avec une précision d'au moins 1-/100 mm à l'aide de trous de fixation (41) et de dents à pointes (56) d'une chaîne à pointes (50) partant des unités d'alimentation (48) pour passer dans la machine à laminer (45) ces plaquettes étant collées aussitôt après en une plaque multi-couches dans la machine à laminer, par application de chaleur et de pression.

18. Dispositif selon la revendication 16, caractérisé en ce que plusieurs bandes de couches individuelles sur lesquelles se trouvent des couches individuelles séparées par des écarts déterminés à l'avance, avec des bandes à couche de colle (60) introduites dans l'intervalle et déroulées à partir d'unités de déroulement (46), sont centrées avec une précision d'au moins 1/100 mm à l'aide des trous de fixation (41) et des dents à pointes (56), d'une chaîne à pointes (50) passant à travers la machine à laminer (45) et provenant des unités de déroulement (46), ces bandes étant amenées à la machine à laminer (45) et collées aussitôt après une bande multi-couches par application de chaleur et de pression.

0 120 192

Fig. 1

Fig. 2

Fig. 3

Fig. 4

Fig. 6

Fig. 5

Fig. 7